# FASCICULE DE BREVET EUROPEEN

(11) **EP 3 579 255 B1**
(45) Date de publication et mention de la délivrance du brevet: **24.03.2021**
(21) Numéro de dépôt: 19176496.8
(22) Date de dépôt: 24.05.2019
(51) Int. Cl.: H01F 17/00, H01F 21/02

(54) **CIRCUIT INTEGRE COMPORTANT UNE INDUCTANCE VARIABLE**
INTEGRIERTER SCHALTKREIS, DER EINE VERÄNDERLICHE INDUKTIVITÄT UMFASST
INTEGRATED CIRCUIT COMPRISING VARIABLE INDUCTANCE

(30) Priorité: 30.05.2018 FR 1854622
(43) Date de publication de la demande: 11.12.2019
(73) Titulaire: Commissariat à l'Énergie Atomique et aux Énergies Alternatives, 75015 Paris (FR)
(72) Inventeur: VIALA, Bernard, 38054 GRENOBLE CEDEX 09 (FR)
(74) Mandataire: Colombo, Michel

(56) Documents cités:
- EP-A1- 1 213 729
- WO-A1-2011/034205
- WO-A1-2011/118072
- WO-A1-2017/217308
- FR-A1- 2 525 776
- US-A1- 2004 238 929
- US-A1- 2015 008 767
- US-B1- 6 493 861

## Description

L'invention concerne un circuit intégré comportant une inductance.

Des circuits intégrés connus comportent :
- un substrat s'étendant principalement dans un plan appelé « plan du substrat »,
- une inductance comportant une première et une deuxième bobines couplées magnétiquement l'une à l'autre, ce couplage magnétique se traduisant par l'existence d'une inductance mutuelle M entre ces deux bobines lorsque l'inductance est alimentée, cette inductance mutuelle M étant définie par la relation suivante : M = k sqrt(L₁L₂), où :
   - k est un coefficient de couplage magnétique, la valeur absolue de ce coefficient k étant comprise dans l'intervalle ]0,4 ; 1], et
   - L₁ et L₂ sont les inductances propres de, respectivement, la première et la deuxième bobines,
   - sqrt(...) est la fonction racine carrée.

Par exemple, un tel circuit intégré est divulgué en référence à la figure 11c de la demande US5095357.

De l'état de la technique est également connu de US2015/008767A1, WO2011/118072A1, EP1213729A1, WO2017/217308A1, WO2011/034205A1, FR2525776A1, US2004/238929A1, US6493861B1. Aucun de ces documents ne divulgue une inductance variable et un circuit de réglage avec des interrupteurs.

L'intérêt d'utiliser deux bobines pour former une inductance est que cet agencement permet d'obtenir aussi bien des inductances très petites, c'est-à-dire inférieures à 100 pH que des inductances beaucoup plus grandes, c'est-à-dire plus grandes que l'inductance propre de chacune de ces bobines. Pour cela, la valeur absolue du coefficient k de couplage magnétique entre les bobines doit être importante, c'est-à-dire supérieur à 0,4 ou 0,5. Pour rappel, la valeur absolue du coefficient k de couplage magnétique ne peut pas dépasser un. A cet effet, les bobines sont agencées l'une par rapport à l'autre de manière à être fortement couplées magnétiquement entre elles. De plus, souvent, pour accroître le couplage magnétique entre les bobines, celles-ci sont bobinées autour d'un noyau magnétique commun.

Dans le cas de l'inductance d'un circuit intégré, chacune de ces bobines est en forme de boucle ou de spirale comme décrit dans US5095357 ou EP1213729. Cette boucle ou cette spirale est réalisée dans une couche de métallisation parallèle au plan du substrat du circuit intégré. Ces bobines sont disposées l'une au-dessus de l'autre et séparées mécaniquement par une couche en matériau diélectrique. De plus, dans le cas des circuits intégrés, le substrat comporte généralement au moins une couche en matériau conducteur ou semi-conducteur tel que du silicium. Dans ce cas, lorsque l'inductance est alimentée, les bobines génèrent des courants de Foucault dans cette couche conductrice ou semi-conductrice, ce qui dégrade les performances de l'inductance. Par exemple, cela dégrade fortement son facteur de qualité et modifie la valeur de son inductance effective.

Pour limiter ce problème, il a déjà été proposé d'isoler magnétiquement la couche conductrice ou semi-conductrice des bobines en introduisant un écran électromagnétique tel qu'un plan de masse segmenté entre les bobines et cette couche conductrice ou semi-conductrice. Dans ce dernier cas, le plan de masse doit être aussi éloigné que possible des bobines pour limiter les couplages capacitifs entre ce plan de masse et ces bobines. Ainsi, cette solution complexifie la réalisation du circuit intégré.

L'invention vise à proposer un tel circuit intégré dans lequel la génération de courant de Foucault par les bobines est limitée tout en restant simple à fabriquer. Elle a donc pour objet un circuit intégré conforme à la revendication 1.

Les modes de réalisation de ce circuit intégré peuvent comporter une ou plusieurs des caractéristiques des revendications dépendantes.

L'invention sera mieux comprise à la lecture de la description qui va suivre, donnée uniquement à titre d'exemple non limitatif et faite en se référant aux dessins sur lesquels :
- la figure 1 est une illustration schématique en coupe verticale d'un circuit intégré comportant une inductance ;
- la figure 2 est un schéma électronique d'un filtre comportant l'inductance du circuit intégré de la figure 1 ;
- la figure 3 est une illustration schématique, en vue de dessus, d'une bobine de l'inductance du circuit intégré de la figure 1 ;
- les figures 4, 5 et 6 sont des schémas électroniques d'un circuit de réglage de l'inductance du circuit intégré de la figure 1 ;
- les figures 7 et 8 sont des illustrations schématiques, en coupe verticale, de deux bobines de l'inductance du circuit intégré de la figure 1 ;
- les figures 9 et 10 sont des schémas électroniques de deux variantes possibles du circuit de réglage de la figure 4 ;
- la figure 11 est un schéma électronique d'une variante du circuit intégré de la figure 1, dans laquelle l'inductance est une inductance fixe ;
- la figure 12 est une illustration schématique, en coupe verticale, d'une variante de l'inductance du circuit intégré de la figure 1 ;
- les figures 13 à 17 sont des illustrations schématiques, en vue de dessus, de différents modes de réalisation possibles de la bobine de l'inductance du circuit intégré de la figure 1 ;
- les figures 18 à 21 sont des illustrations schématiques, en vue de dessus, de différents agencement possibles d'une bobine par rapport à l'autre bobine de l'inductance.

Dans ces figures, les mêmes références sont utilisées pour désigner les mêmes éléments. Dans la suite de cette description, les caractéristiques et fonctions bien connues de l'homme du métier ne sont pas décrites en détail.

### Chapitre I : Description détaillée de modes de réalisation :

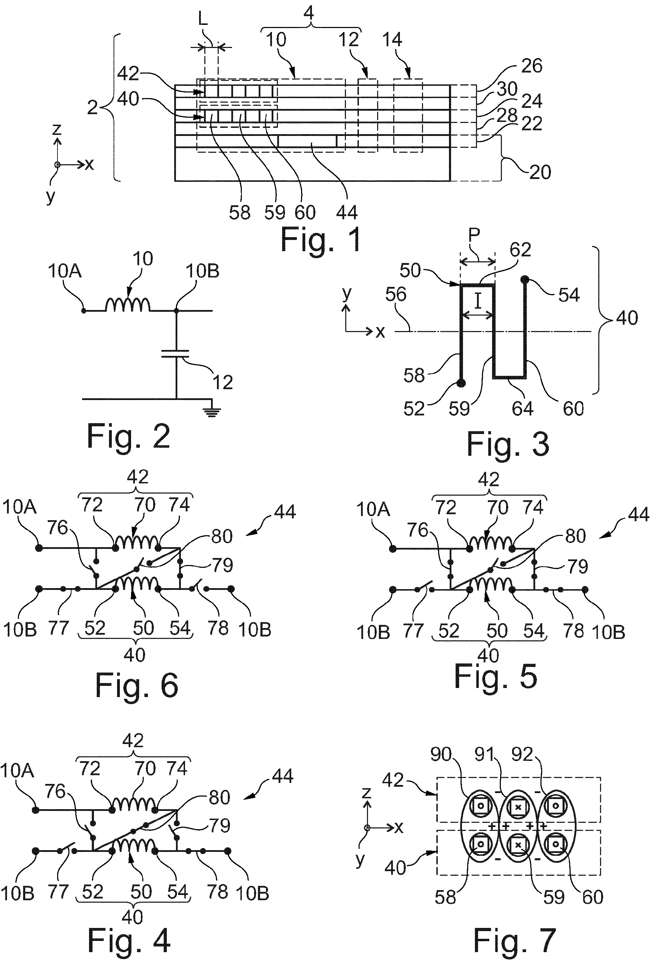

La figure 1 représente un circuit intégré 2 qui comporte un filtre passe-bas réglable 4. Le schéma électrique du filtre 4 est représenté sur la figure 2. Ce filtre 4 comporte une inductance 10 et un condensateur 12. La fréquence de coupure f_{c} du filtre 4 est donnée par la relation suivante : f_{c} = 1/(2π sqrt(LC)), où :
- L est la valeur de l'inductance 10,
- C est la capacité du condensateur 12, et
- sqrt(...) est la fonction racine carrée.

L'inductance 10 comporte une borne d'entrée 10A et une borne de sortie 10B. Ici, la borne 10A reçoit le signal électrique à filtrer. La borne 10B est raccordée au condensateur 12.

La fréquence f_{c} peut être réglée pour prendre, en alternance, une valeur parmi trois valeurs différentes notées f₁, f₂ et f₃ par la suite. L'objectif est d'obtenir un filtre 4 dans lequel la valeur f₁ est au moins deux fois, et de préférence au moins cinq ou dix fois, plus grande que la valeur f₃. La valeur f₂ est une valeur intermédiaire entre les valeurs f₁ et f₃. Pour cela, dans ce mode de réalisation, l'inductance 10 est une inductance variable qui peut être réglée pour prendre, en alternance, une valeur parmi trois valeurs différentes notées L₁, L₂ et L₃. Dans ce mode de réalisation, la capacité du condensateur 12 est fixe et ne peut pas être réglée. Dans ces conditions, pour que la valeur f₁ soit deux fois supérieure à la valeur f₃, il faut que la valeur L₁ de l'inductance 10 soit quatre fois inférieure à la valeur L₃. La valeur L₂ de l'inductance 10 permet d'obtenir la valeur f₂ de la fréquence de coupure f_{c}.

Comme représenté par un carré en pointillés sur la figure 1, le circuit intégré 2 peut aussi comporter d'autres composants électroniques 14 qui ne seront pas décrits ici en détail.

Le circuit intégré 2 comporte un substrat 20 comportant au moins une couche 22 en matériau semi-conducteur ou conducteur, à l'intérieur de laquelle sont réalisés des composants électroniques ou optiques. Ici, la couche 22 est réalisée en matériau semi-conducteur tel que du silicium monocristallin.

Ce substrat 20 s'étend principalement dans un plan horizontal appelé par la suite « plan du substrat ».

Sur la figure 1 et les suivantes, l'horizontal est repéré par deux directions X et Y d'un repère orthogonal. La direction Z de ce repère orthogonal correspond à la direction verticale.

Par la suite, les termes tels que « au-dessus », « au-dessous », « supérieur », « inférieur », sont définis par rapport à la direction Z.

Au-dessus du substrat 20, le circuit intégré comporte un empilement de couches de métallisation séparées mécaniquement les unes des autres par des couches diélectriques réalisées en matériau électriquement isolant. Dans cette demande, par « matériau électriquement isolant » ou « matériau isolant », on désigne un matériau dont la conductivité à 20°C est inférieure à 10⁻⁶ S/m ou 10⁻¹⁰ S/m. Ici, les couches diélectriques sont réalisées en dioxyde de silicium (SiO₂). Typiquement, les couches de métallisation sont réalisées pendant une phase de fabrication du circuit intégré 2 connue sous l'acronyme BEOL (« Back End Of Line »).

Pour simplifier la figure 1, seules deux couches de métallisation 24 et 26 et seules deux couches diélectriques 28 et 30 sont représentées. En allant du bas vers le haut, l'empilement de couches sur le substrat 20 est le suivant : la couche diélectrique 28, la couche de métallisation 24, la couche diélectrique 30 et la couche de métallisation 26. La couche diélectrique 30 est donc interposée entre les couches de métallisation 24 et 26. Les couches de métallisation 24 et 26 sont par exemple choisies parmi les couches de métallisation situées dans les niveaux connus sous les références M5 à M9. Ces couches de métallisation sont réalisées en matériau conducteur. Dans cette demande, par « matériau conducteur » ou « matériau électriquement conducteur », on désigne un matériau dont la conductivité électrique à 20°C est supérieure à 10⁵ S/m ou 10⁶ S/m. Ici, les couches de métallisation sont en cuivre. L'épaisseur de chaque couche de métallisation est par exemple comprise entre 0,5 µm et 40 µm et, généralement, comprise entre 0,5 µm et 5 µm.

L'épaisseur, notée par la suite « e », de la couche diélectrique 30 est par exemple comprise entre 0,5 µm et 50 µm et, généralement, entre 0,5 µm et 10 µm. Cette épaisseur « e » est choisie comme cela sera expliqué plus loin pour obtenir une valeur souhaitée d'un coefficient k de couplage magnétique.

L'inductance 10 comporte deux bobines 40 et 42 en forme de serpentin et un circuit commandable 44 de réglage de la valeur de l'inductance 10. Chaque bobine 40, 42 est entièrement réalisée dans une seule et même couche de métallisation. Par exemple, ces bobines sont réalisées par photo-lithographie et donc notamment par gravure de cette couche de métallisation. Ici, les bobines 40 et 42 sont réalisées, respectivement, dans les couches de métallisation 24 et 26.

Dans ce mode de réalisation, les bobines 40 et 42 sont structurellement identiques. Ainsi, par la suite, seule la structure de la bobine 40 est décrite plus en détail. De plus, elles sont disposées l'une au-dessus de l'autre dans la direction verticale de manière à être fortement couplées magnétiquement l'une à l'autre.

Dans cette demande, par « fortement couplées magnétiquement », on désigne le fait que la valeur absolue du coefficient k de couplage magnétique entre les bobines 40 et 42 est supérieure à 0,4 ou 0,5 et, de préférence supérieure à 0,6 ou 0,8 ou 0,9. Le coefficient k de couplage magnétique est celui utilisé pour définir la valeur de l'inductance mutuelle entre les bobines 40 et 42. On rappelle que la valeur de l'inductance mutuelle est donnée par la relation suivante : M = k sqrt(L₄₀L₄₂), où :
- L₄₀ et L₄₂ sont les valeurs de l'inductance propre, respectivement, des bobines 40 et 42,
- k est le coefficient de couplage magnétique.

L'inductance propre est également connue sous le terme anglais de « self inductance ». La valeur du coefficient k dépend notamment de la proximité des bobines l'une par rapport à l'autre, de l'épaisseur « e » de la couche 30 et de l'agencement des bobines l'une par rapport à l'autre. Enfin, le coefficient k dépend aussi de la perméabilité relative µᵣᵥ, dans la direction verticale, du matériau de la couche 30. Ici, le matériau de la couche 30 ne présente pas de propriété magnétique et sa perméabilité µᵣᵥ est égale à 1. Ici, la perméabilité relative µᵣᵥ est mesurée dans des conditions normales de température et de pression.

Dans ce mode de réalisation, les bobines 40, 42 sont agencées l'une au-dessus de l'autre de manière à ce que la projection orthogonale de la bobine 40 dans un plan horizontal est confondue avec la projection orthogonale de la bobine 42 dans ce même plan horizontal. Dans ce cas, la surface de l'intersection des projections orthogonales des bobines 40 et 42 sur un même plan horizontal est égale à 100 % de la surface de la projection orthogonale de chacune des bobines 40 et 42 sur ce plan horizontal. Avec un tel agencement des bobines 40 et 42 et en choisissant l'épaisseur « e » dans la plage d'épaisseurs possibles donnée ci-dessus, la valeur absolue du coefficient k du couplage magnétique entre ces bobines 40 et 42 est facilement rendue supérieure à 0,4 ou 0,5 et, en réduisant l'épaisseur e, supérieure à 0,8 ou 0,9 ou 0,95.

La figure 3 représente plus en détail la structure de la bobine 40. La bobine 40 est constituée dans ce mode de réalisation d'une seule ligne 50 de métal. Cette ligne 50 s'étend horizontalement depuis une extrémité 52 jusqu'à une extrémité 54 en serpentant autour d'un axe 56 horizontal de la bobine 40. Ici, l'axe 56 est parallèle à la direction X et la ligne 50 s'étend de l'extrémité 52 jusqu'à l'extrémité 54 en avançant dans cette direction X. La largeur de la ligne 50, notée « L » (figure 1) est constante sur toute sa longueur et généralement comprise entre 1 µm et 100 µm et, de préférence, comprise entre 1 µm et 20 µm ou entre 1 µm et 10 µm. La ligne 50 est par exemple fabriquée en mettant en œuvre les mêmes procédés que ceux utilisés pour fabriquer les composants CMOS (« Complementary Metal Oxide Semiconductor »).

La ligne 50 comporte une succession de N brins qui coupent chacun l'axe 56. N est un nombre entier supérieur ou égal à deux ou trois et généralement inférieur à cent. Ici, pour simplifier la figure 3, seuls trois brins 58 à 60 sont représentés.

Dans ce mode de réalisation, les brins 58 à 60 sont identiques les uns aux autres et espacés les uns des autres dans la direction X d'une distance identique noté « I » sur la figure 3. La distance « I » est donc la distance, mesurée le long de l'axe 56, qui sépare deux brins immédiatement adjacents dans la direction X.

Dans cette description, par « deux brins immédiatement adjacents dans la direction X » on désigne deux brins de la même ligne qui sont, dans la direction X, l'un à côté de l'autre et entre lesquels aucun autre brin de la ligne n'est interposé. Ainsi, le brin immédiatement adjacent au brin 58 dans la direction X est le brin 59 et le brin immédiatement adjacent au brin 59 dans la direction X est le brin 60.

De préférence, la distance « I » est petite devant la largeur « L » de la ligne 50 de manière à ce que deux brins immédiatement adjacents dans la direction X de la ligne 50 soient magnétiquement couplés ensemble. Pour qu'il existe un bon couplage magnétique entre les brins immédiatement adjacents dans la direction X, la distance « I » et la largeur « L » de la ligne 50 sont choisis tels que le rapport I/L soit inférieur à trois ou un. De préférence, le rapport I/L est inférieur à 0,1 ou à 0,05 voire même inférieur à 0,02.

De façon avantageuse, l'épaisseur « e » est également petite devant la largeur « L » de la ligne 50. Toutefois, l'épaisseur « e » ne doit pas être trop petite pour ne pas créer une capacité parasite entre les bobines 40 et 42 trop importante. Ainsi, en général, l'épaisseur « e » est choisie telle que le rapport e/L soit supérieur à 0,1 et, typiquement, inférieur à 0,5.

De façon avantageuse, l'épaisseur « e » est également petite devant la distance « I » de la ligne 50. Ainsi, en général, l'épaisseur « e » est choisie telle que le rapport e/I soit inférieur à 0,5 et, typiquement, inférieur à 0,1.

Puisque la distance « I » est constante et que les brins 58 à 60 sont identiques les uns aux autres, ces brins 58 à 60 sont répétés le long de l'axe 56 avec un pas régulier « P » (Figure 3).

Seul le brin 58 est maintenant décrit plus en détail. Le brin 58 coupe l'axe 56 au niveau de son centre de gravité. Ici, le brin 58 est rectiligne et s'étend parallèlement à la direction Y. Dans ces conditions, le brin 58 coupe l'axe 56 au niveau de son milieu.

Les brins de la ligne 50 sont raccordés électriquement en série les uns aux autres de manière à ce que le courant qui circule dans un brin donné quelconque soit systématiquement en opposition de phase avec le courant qui circule, au même instant, dans le brin immédiatement adjacent dans la direction X. A cet effet, ici, le brin immédiatement adjacent au brin 58 dans la direction X est donc le brin 59 et le brin immédiatement adjacent au brin 59 dans la direction X est le brin 60. L'extrémité du brin 58 située en dessous de l'axe 56 sur la figure 3 est confondue avec l'extrémité 52. L'extrémité du brin 58 située au-dessus de l'axe 56 sur la figure 3 est électriquement raccordée en série, par l'intermédiaire d'un brin supplémentaire 62, avec l'extrémité du brin 59 elle aussi située au-dessus de l'axe 56 dans la figure 3. L'extrémité du brin 59 située en dessous de l'axe 56 dans la figure 3 est électriquement raccordée en série, par l'intermédiaire d'un brin supplémentaire 64, avec l'extrémité du brin 60 située sous l'axe 56 dans la figure 3. L'extrémité du brin 60 située au-dessus de l'axe 56 dans la figure 3 est confondue avec l'extrémité 54.

Les brins supplémentaires 62 et 64 qui sont utilisés pour raccorder les brins 58 à 60 en série, ne coupent pas l'axe 56. Ici, ces brins 62 et 64 sont rectilignes et s'étendent parallèlement à la direction X.

Par la suite, la ligne de métal de la bobine 42 est désignée par la référence 70 (figure 4). Les extrémités de la ligne 70 situées à la verticale des extrémités 52 et 54, portent, respectivement, les références numériques 72 et 74 (figure 4).

Le circuit 44 de réglage est apte à faire varier le sens et/ou l'intensité du courant qui circule dans la bobine 40 par rapport au sens et/ou l'intensité du courant qui circule au même instant dans la bobine 42. Une telle variation du sens et/ou de l'intensité du courant dans l'une des bobines par rapport à l'autre modifie la valeur de l'inductance mutuelle entre ces bobines et donc la valeur L de l'inductance 10.

Un premier mode de réalisation de ce circuit 44 est représenté sur la figure 4. Dans ce premier mode de réalisation, le circuit 44 comporte cinq interrupteurs commandables 76 à 80. Chacun de ces interrupteurs 76 à 80 est commutable de façon réversible, en réponse à un signal de commande, entre une position ouverte et une position fermée. Dans la position fermée, la résistance de l'interrupteur est faible (par exemple 1 Ohm) et il laisse passer le courant. Dans la position ouverte, la résistance de l'interrupteur est dix ou cent fois plus élevée et l'interrupteur empêche le courant de passer. Ici, il s'agit d'interrupteurs capables de conduire et, en alternance, d'interrompre le passage d'un courant haute fréquence. Par « courant haute fréquence », on désigne dans cette demande un courant alternatif dont la fréquence fondamentale est supérieure à 1 GHz ou 10 GHz ou 40 GHz. Dans ce mode de réalisation, les interrupteurs sont de préférence des interrupteurs à matériaux à changement de phase. Ces matériaux sont plus connus sous l'acronyme PCM (« Phase-change material »). Par exemple, le matériau utilisé est du dioxyde de vanadium (VO₂). La commutation d'un tel interrupteur entre ces positions ouverte et fermée est par exemple commandée en faisant varier sa température. Ces interrupteurs sont bien connus. Par exemple, le lecteur peut consulter à ce sujet l'article suivant : Shu Wang et Al : « Tunable inductors using vanadium dioxide as the control material », Microwave and Optical Technology Letters, volume 59, n° 5, mai 2017, pages 1057 à 1061.

Par exemple, le circuit 44 et ses interrupteurs sont réalisés dans la couche 22 de façon conventionnelle. Le circuit 44 est raccordé aux bobines 40 et 42, par exemple, par des vias métalliques traversant les couches diélectrique 28 et 30.

Ici, les interrupteurs 76 à 80 sont agencés pour raccorder, en alternance, les bobines 40 et 42 selon une première, une deuxième et une troisième configurations représentées, respectivement, sur les figures 6, 4 et 5. A cet effet, l'interrupteur 76 est directement raccordé entre les extrémités 52 et 72. Dans cette demande, par « directement raccordé », on désigne le fait que le composant est électriquement raccordé sans passer par l'intermédiaire d'une des bobines 40 ou 42. En général, le composant est donc directement raccordé par l'intermédiaire d'une simple liaison filaire. L'interrupteur 77 est directement raccordé entre la borne 10B et l'extrémité 52. L'interrupteur 78 est directement raccordé entre l'extrémité 54 et la borne 10B. L'interrupteur 79 est directement raccordé entre les extrémités 54 et 74. L'interrupteur 80 est directement raccordé entre les extrémité 52 et 74.

Selon la première configuration (figure 6), les interrupteurs 77 et 79 sont en position fermée et les interrupteurs 76, 78 et 80 sont en position ouverte. Dans cette configuration, les bobines 40 et 42 sont raccordées en série entre les bornes 10A et 10B. De plus, dans cette première configuration, le courant qui circule dans le brin 58 est en opposition de phase avec le courant alternatif qui circule, au même instant, dans le brin de la bobine 42 qui lui est immédiatement adjacent dans la direction verticale. Le brin de la bobine 42 immédiatement adjacent au brin 58 est le brin de la bobine 42 qui est le plus proche du brin 58. Il s'agit donc ici du brin de la bobine 42 situé immédiatement au-dessus du brin 58 dans la direction Z. Ce qui vient d'être décrit dans le cas particulier du brin 58 s'applique aussi aux brins 59 et 60.

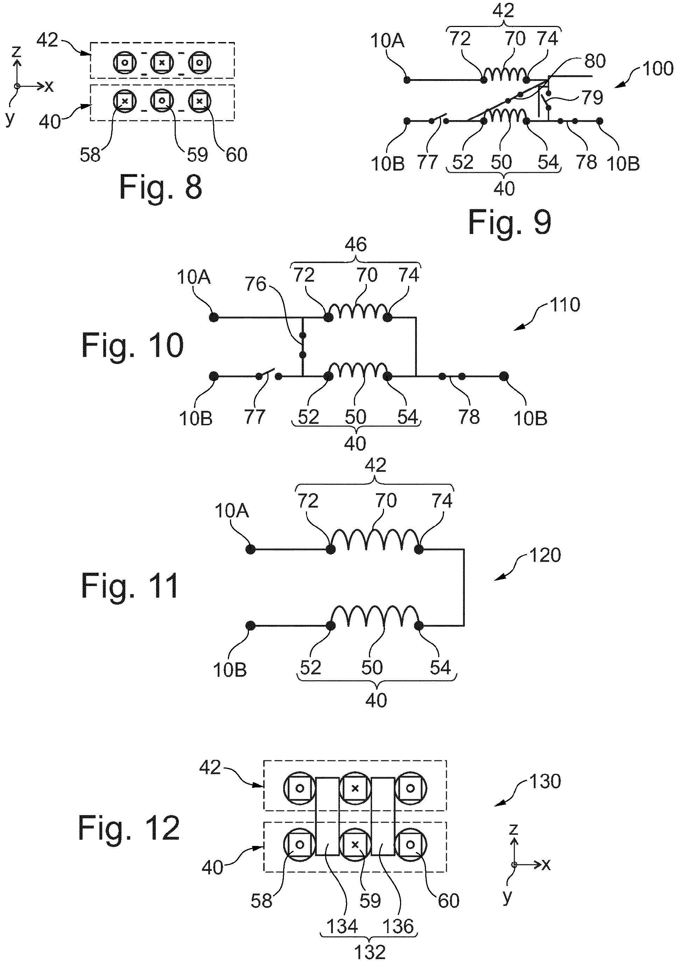

Le sens de circulation dans les brins des bobines 40 et 42 raccordés selon la première configuration est représenté sur la figure 8. Sur cette figure 8, un point à l'intérieur d'un brin indique que le courant circule dans ce brin dans la direction opposée à la direction Y. A l'inverse, une croix à l'intérieur d'un brin indique que le courant circule dans ce brin dans la direction Y. Dans le cas de la première configuration, les lignes de champs générées par les bobines 40 et 42 se combinent de façon destructive. Dès lors, l'inductance mutuelle M vient se soustraire à l'inductance propre de chacune des bobines 40 à 42. La valeur L₁ de l'inductance 10 est alors donnée par la relation suivante : L₁ = 2Lₚ(1-|k|), où :
- Lₚ est valeur de l'inductance propre de la bobine 40 ou 42, et
- le symbole |k| désigne la valeur absolue du coefficient k.
Ici, puisque les bobines 40 et 42 sont identiques, elles ont la même valeur Lₚ d'inductance propre .

Selon la troisième configuration (figure 5), les interrupteurs 76, 78 et 79 sont en position fermée et les interrupteurs 77 et 80 sont en position ouverte. Dans cette troisième configuration, les bobines 40 et 42 sont raccordées en parallèle entre les bornes 10A et 10B. Dans cette troisième configuration, le courant qui circule dans le brin 58 est en phase avec le courant alternatif qui circule, au même instant, dans le brin de la bobine 42 qui lui est immédiatement adjacent. Ceci s'applique aussi aux brins 59 et 60. Toutefois, toute chose égale par ailleurs, dans cette troisième configuration, l'intensité du courant qui circule dans chacune des bobines 40 et 42 est divisée par deux par rapport à l'intensité du courant qui circulerait dans ces bobines si celles-ci étaient raccordées l'une à l'autre selon la première configuration. Ainsi, dans cette troisième configuration, la valeur L₂ de l'inductance 10 est définie par la relation suivante : L₂ = 0,5Lₚ(1+|k|).

Selon la deuxième configuration (figure 4), les interrupteurs 78 et 80 sont en position fermée et les interrupteurs 76, 77 et 79 sont en position ouverte. Selon cette deuxième configuration, les bobines 40 et 42 sont raccordées en série entre les bornes 10A et 10B. Par contre, contrairement à la première configuration, le courant qui circule dans le brin 58 est en phase avec le courant qui circule, au même instant, dans le brin de la bobine 42 qui lui est immédiatement adjacent. Ceci se vérifie aussi pour les brins 59 et 60. En employant les mêmes notations que celles définies en référence à la figure 8, le sens de circulation du courant dans les brins des bobines 40 et 42 a été représenté sur la figure 7 dans le cas de cette deuxième configuration. Les lignes 90, 91 et 92 (figure 7) autour de chaque paire de brins superposés verticalement symbolisent le fait que les lignes de champs générées par ces brins se combinent constructivement. Ainsi, l'inductance mutuelle M vient s'ajouter à l'inductance propre de chacune des bobines 40 et 42. Selon cette deuxième configuration, la valeur L₃ de l'inductance 10 est définie par la relation suivante : L₃ = 2Lₚ(1+|k|).

Le rapport L₃/L₁ est égal à (1+|k|)/(1-|k|). Ce rapport est donc d'autant plus grand que le coefficient k est grand. Par exemple, il est possible d'atteindre un rapport L₃/L₁ égal à cent lorsque le coefficient k est égal à 0,98.

Lors du fonctionnement du circuit intégré 2, en fonction de la fréquence f_{c} souhaitée, un signal de commande est transmis à l'inductance 10. En réponse, le circuit 44 commute les interrupteurs 76 à 80 pour obtenir la configuration correspondante à la fréquence f_{c} souhaitée.

La figure 9 représente un circuit 100 de réglage susceptible d'être utilisé à la place du circuit 44. Le circuit 100 est identique au circuit 44 sauf que l'interrupteur 76 est omis. Le circuit 100 permet donc seulement de réaliser les première et deuxième configurations précédemment décrites. Dans ce cas, l'inductance 10 variable peut uniquement prendre les valeurs L₁ et L₃.

La figure 10 représente un circuit 110 de réglage susceptible d'être utilisé à la place du circuit 44. Le circuit 110 est identique au circuit 4 sauf que l'interrupteur 80 est omis et que l'interrupteur 79 est remplacée par une liaison filaire entre les extrémités 54, 74. Le circuit 110 permet donc seulement de réaliser les première et troisième configurations précédemment décrites. Dans ce cas, l'inductance variable peut uniquement prendre les valeurs L₁ et L₂.

La figure 11 représente une inductance 120 qui n'est pas protégé par la présente demande. L'inductance 120 est susceptible d'être utilisée à la place de l'inductance 10. L'inductance 120 est identique à l'inductance 10 sauf que le circuit 44 de réglage est omis et que les bobines 40 et 42 sont raccordées en permanence selon la première configuration. Dans ce mode de réalisation, les bobines 40, 42 sont agencées l'une par rapport à l'autre de manière à ce que la valeur absolue du coefficient k soit supérieure à 0,6 et, de préférence, supérieure à 0,9 ou 0,95. Typiquement, à cet effet, l'épaisseur « e » de la couche 30 est réduite jusqu'à atteindre la valeur souhaitée du coefficient k. Dans ces conditions, la valeur de l'inductance 120 est, généralement, inférieure à 100 pH ou 10 pH. De telles inductances de très faible valeur sont notamment utiles pour les applications très haute fréquence, c'est-à-dire des applications où la fréquence fondamentale du courant électrique qui traverse l'inductance 120 est supérieure à 20 GHz ou 40 GHz.

La figure 12 représente une inductance 130 susceptible d'être utilisée à la place de l'inductance 10 ou de l'inductance 120. L'inductance 130 est identique à l'inductance 10 ou 120 sauf qu'elle comporte en plus un noyau magnétique 132 pour augmenter la valeur du coefficient k de couplage magnétique entre les bobines 40 et 42. Pour simplifier la figure 12. Seules les bobines 40 et 42 et le noyau 132 sont représentés.

Le noyau 132 concentre les lignes de champ magnétique générées par la bobine 40 et les guide jusqu'à la bobine 42. A cet effet, le noyau 132 comporte des barreaux magnétiques 134 et 136 qui s'étendent verticalement à travers la couche diélectrique 30. Ici, le barreau 134 comporte une partie inférieure située entre les brins 58 et 59. Le barreau 134 s'étend verticalement depuis cette partie inférieure jusqu'à une partie supérieure située entre les barreaux de la bobine 42 immédiatement adjacents, respectivement, aux barreaux 58 et 59. Le barreau 134 est réalisé dans un matériau magnétique dont la perméabilité relative µᵣᵥ dans la direction verticale est strictement supérieure à 1 et supérieure à sa perméabilité relative µᵣₕ dans la direction X. Par exemple, le barreau 134 est constitué d'une matrice poreuse en alumine (Al₂O₃) à l'intérieur de laquelle sont noyés des nanofils magnétiques qui s'étendent principalement verticalement. Le barreau 134 peut aussi être constitué d'une matrice en matériau polymère à l'intérieur de laquelle sont noyées des nanoparticules magnétiques incorporées dans cette matrice. Ces nanoparticules magnétiques sont agencées à l'intérieur de cette matrice pour former des chaînes de nanoparticules qui s'étendent principalement verticalement. Un procédé de fabrication d'un tel barreau magnétique est par exemple décrit dans la demande EP3028855 en utilisant des nanoparticules magnétiques à la place des nanoparticules conductrices.

Le barreau 136 est par exemple identique au barreau 134 sauf qu'il est placé entre les brins 59 et 60.

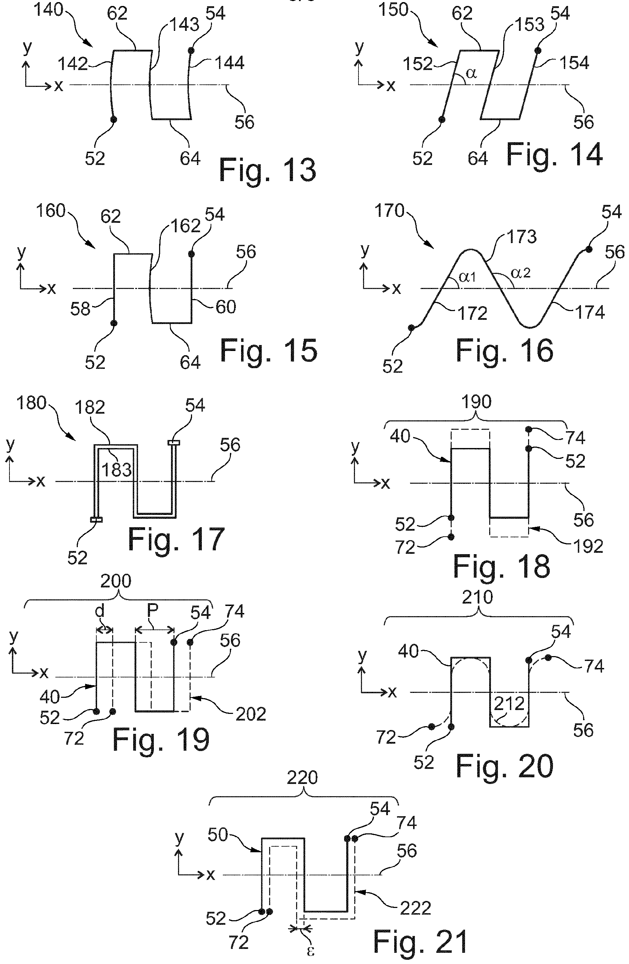

Les figures 13 à 17 représentent d'autres modes de réalisation possibles d'une bobine en forme de serpentin susceptible d'être employée à la place des bobines 40 et 42 pour réaliser l'inductance 10, 120 ou 130. Pour simplifier ces figures et les suivantes, la ligne de métal qui compose cette bobine est simplement représentée sous la forme d'un trait.

La figure 13 représente une bobine 140 identique à la bobine 40, sauf que les brins 58 à 60 sont remplacés, respectivement, par des brins 142 à 144. Les brins 142 à 144 sont identiques aux brins 58 à 60 sauf qu'ils sont en forme d'arc de cercle au lieu d'être rectilignes. Chacun de ces brins 142 à 144 est symétrique par rapport à l'axe 56. Le rayon de courbure de chacun de ces brins 142 à 144 est deux fois ou dix fois supérieur au pas « P » de manière à ne pas former une boucle.

La figure 14 représente une bobine 150 identique à la bobine 40, sauf que les brins 58 à 60 sont remplacés, respectivement, par des brins 152 à 154. Les brins 152 à 154 sont identiques aux brins 58 à 60 sauf qu'ils coupent l'axe 156 en formant un angle 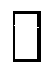 différent de 90°. Par exemple, l'angle 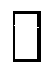 est compris entre 50° et 80°.

La figure 15 représente une bobine 160 identique à la bobine 40, sauf que le brin 59 est remplacé par un brin 162. Le brin 162 n'est pas identique au brin 58 qui le précède immédiatement. Par exemple ici, le brin 162 est identique au brins 143 alors que les brins 58 et 60 sont rectilignes.

La figure 16 représente une bobine 170 identique à la bobine 40, sauf que les brins 58 à 60 sont remplacés, respectivement, par des brins 172 à 174. Ici, la ligne de métal de la bobine 170 serpente autour de l'axe 56 en suivant un parcours en forme de sinusoïde ou de dents de scie. Dans ce mode de réalisation, la tangente au niveau de l'intersection entre le brin 172 et l'axe 56 forme un angle 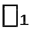 inférieur à 90° et généralement inférieur à 80° ou 60°. La tangente au niveau de l'intersection entre le brin 173 et l'axe 56 forme un angle 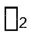 égal à (180° - 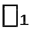 ). En d'autres termes, le brin 172 est incliné dans un sens et le brin 173 est incliné dans le sens opposé. Ainsi, si l'on prolonge les axes tangents aux brins 172 et 173 au niveau de leur intersection avec l'axe 56, ces axes se coupent. Dans ces conditions, les brins supplémentaires 62, 64 peuvent être omis.

La figure 17 représente une bobine 180 identique à la bobine 40, sauf qu'elle comporte Q lignes de métal qui serpentent autour de l'axe 56 en restant pratiquement toujours parallèle l'une à l'autre, où Q est un nombre entier supérieur à deux et, de préférence, supérieur à trois ou cinq. On obtient ainsi une structure pour les conducteurs utilisés pour former la bobine 180 similaire à celle connue sous le terme de « fil Litz ». Ici, pour simplifier la figure 17, seuls deux lignes de métal 182 et 183 sont représentées. Ces deux lignes 182 et 183 sont en contact mécanique et électrique l'une avec l'autre uniquement au niveau des extrémités 52 et 54. Prise individuellement, chacune de ces lignes 182 et 183 présente une structure identique ou très similaire à la ligne 50. Le fait d'utiliser plusieurs lignes de métal réduit la résistivité de l'inductance 180.

Les figures 18 à 21 représentent différents agencements possibles des deux bobines, l'une par rapport à l'autre, pour former une inductance susceptible d'être employée à la place de l'inductance 10, 120 ou 130.

Les figures 18 à 20 représentent des modes de réalisations où la surface de l'intersection entre les projections orthogonales des deux bobines sur le même plan horizontal est inférieure à la surface de la projection orthogonale d'une de ces bobines sur ce plan horizontal.

La figure 18 représente une inductance 190 identique à l'inductance 10, 120 ou 130, sauf que la bobine 42 est remplacée par une bobine 192 représentée par une ligne en traits pointillés. La bobine 192 est identique à la bobine 42 sauf que la longueur de chacun des brins parallèles à la direction X est augmentée. Dans ce cas, les projections orthogonales des extrémités 72, 74 de la bobine 192 sur un plan horizontal ne sont pas confondues avec les projections orthogonales sur ce même plan des extrémités 52 et 54. De plus, la surface de l'intersection entre les projections orthogonales des bobines 40 et 192 est plus petite que la surface de la projection orthogonale de la bobine 192 sur ce plan horizontal. Ainsi, dans ce mode de réalisation, la superposition des projections orthogonales des bobines n'est que partielle et non pas parfaite.

La figure 19 représente une inductance 200 identique à l'inductance 10, 120 ou 130, sauf que la bobine 42 est remplacée par une bobine 202. La bobine 202 est identique à la bobine 42 sauf qu'elle est décalée d'une distance d dans la direction X. La distance d est inférieure à P/2 et, de préférence, inférieure à P/4 et avantageusement inférieure à P/8 ou P/16. Dans ce cas, la surface de l'intersection des projections orthogonales des bobines 202 et 40 sur le même plan horizontal peut être négligeable, c'est-à-dire au moins inférieure à 100 fois la surface de la projection orthogonale sur ce plan horizontal de la bobine 202 ou 40. Ici, quel que soit le brin de la bobine 40, sa projection orthogonale sur un plan horizontal est espacée d'une distance inférieure à I/4 de la projection orthogonale d'un brin de la bobine 202 sur ce même plan horizontal. Typiquement, l'espacement entre ces projections orthogonales de deux brins est mesuré le long de la projection orthogonale de l'axe 56 sur ce plan horizontal.

La figure 20 représente une inductance 210 identique à l'inductance 10, 120 ou 130, sauf que la bobine 42 est remplacée par une bobine 212. La forme de la bobine 212 est ici une sinusoïde. La projection orthogonale de la bobine 212 dans un plan horizontal est :
- tangente à la projection orthogonale de la bobine 40 dans ce même plan au niveau des points d'intersection avec la projection orthogonale de l'axe 56 dans ce plan horizontal, et
- tangente aux milieux des projections orthogonales des brins 62 et 64 sur ce plan horizontal.

Dans ce cas aussi, la surface de l'intersection des projections orthogonales des bobines 40 et 212 dans un même plan horizontal est négligeable.

La figure 21 représente une inductance 220 identique à l'inductance 10, 120 ou 130, sauf que la bobine 42 est remplacée par une bobine 222 qui est réalisée dans la même couche de métallisation 24 que la bobine 40. Ainsi, dans ce mode de réalisation, les deux bobines 222 et 40 sont situées dans le même plan horizontal et non pas disposées l'une au-dessus de l'autre. La bobine 222 comporte une ligne de métal 224 qui suit, en conservant un écart constant ε, la ligne de métal 50 et ne croise jamais cette ligne de métal 50. Plus l'écart ε est petit, plus la valeur absolue du coefficient k de couplage magnétique est proche de 1.

### Chapitre II : Variantes :

### Chapitre II.1 : Variantes de la bobine :

Les bobines peuvent être réalisées dans d'autres matériaux conducteurs comme de l'or ou de l'argent.

Les bobines peuvent aussi être fabriquées par d'autres procédés que la photolithographie et la gravure. Par exemple, en variantes, elles sont réalisées par électrolyse, sérigraphie ou impression jet d'encre.

Le nombre N de brins d'une bobine doit être supérieur ou égal à deux et peut être supérieur ou égal à trois, dix ou vingt.

En variantes, la largeur de la ligne 50 n'est pas constante sur toute sa longueur. Par exemple, la largeur des brins 58 à 60 est plus grande que la largeur des brins 62 et 64.

En variantes, le pas « P » qui sépare les différents brins qui coupent l'axe 56 d'une même ligne de métal n'est pas régulier. Dans ce cas, la distance « I » entre deux brins immédiatement consécutifs dans la direction X n'est pas toujours la même.

Les différents modes de réalisation des brins décrits ici et les différents agencements des bobines l'une par rapport à l'autre décrits ici peuvent être combinés de nombreuses façons différentes pour obtenir de nouveaux modes de réalisation. Par exemple, les différentes formes de brins décrites en références aux figures 13 à 17 peuvent être mises en œuvre dans un quelconque des agencements décrits en référence aux figures 18 à 21.

Le brin 180 peut comporter plus de deux lignes de métal parallèles l'une à l'autre. Dans une autre variante, les lignes de métal 182 à 183 ne sont pas parallèles l'une à l'autre.

### Chapitre II.2. Variantes de l'inductance :

Le pas « P » entre les brins adjacents peut être inférieur ou égal à l'épaisseur « e ». Dans ce cas, le rapport e/P est supérieur ou égal à 1.

Dans une autre variante, l'inductance comporte plus de deux ou trois bobines couplées magnétiquement entre elles. Dans ce cas, l'inductance comporte plusieurs paires de bobines immédiatement adjacentes. Par exemple, ces bobines sont superposées les unes au-dessus des autres dans la direction Z. Chaque paire de bobines immédiatement adjacentes est agencée comme décrit ci-dessus dans le cas de l'inductance 10, c'est-à-dire dans le cas d'une inductance comportant seulement une paire de bobines. La valeur de cette inductance à plus de deux bobines peut être variable. Dans ce cas, par exemple, le circuit de réglage décrit dans le cas particulier de deux bobines est adapté pour pouvoir raccorder chaque paire de bobines de cette inductance à plus de deux bobines selon l'une des configurations décrites ci-dessus. En particulier, dans une configuration, toutes les bobines sont raccordées en série et les courants alternatifs qui circulent, aux mêmes instants, dans des brins immédiatement adjacents dans la direction Z sont en opposition de phase. De préférence, dans le cas d'une inductance à plus de deux bobines, le circuit de réglage permet de raccorder certaines paires de bobines adjacentes selon la première configuration et d'autres paires de bobines adjacentes selon la deuxième ou la troisième configuration. Grâce à cela, il est possible de régler un grand nombre de valeurs différentes pour cette inductance à plus de deux bobines. De façon similaire, l'inductance 220 peut comporter plus de deux ou trois bobines couplées magnétiquement les unes aux autres et toutes situées dans la même couche de métallisation.

Dans un autre mode de réalisation, la valeur de l'inductance est réglée non pas en modifiant les connexions électriques entre les bobines et donc, en particulier, en jouant sur le sens de circulation du courant dans ces bobines mais en faisant varier l'intensité du courant dans l'une des bobines. Dans un tel mode de réalisation d'une inductance variable, les interrupteurs commandables sont par exemple omis et remplacés par un circuit, telle qu'une source de courant commandable, apte à modifier l'intensité du courant qui circule dans l'une des bobines. En faisant varier l'intensité du courant dans l'une des bobines, on modifie l'inductance mutuelle et donc la valeur de l'inductance. Ces modes de réalisation d'une inductance variable fonctionnent comme décrit en référence aux figures 15a, 15b, 16a, 16b et 17 de la demande US5095357. Par exemple, ces modes de réalisation se distinguent de ceux décrits dans les figures 15a, 15b, 16a, 16b et 17 de la demande US5095355 simplement par le fait qu'on utilise des bobines en forme de serpentin à la place des bobines en forme de boucle ou de spirale. Grâce à cela, l'induction de courant dans le plan de masse est fortement réduite.

### Chapitre II.3 : Autres variantes :

D'autres matériaux que le dioxyde de vanadium peuvent être utilisés pour réaliser les interrupteurs du circuit 44 de réglage. Par exemple, du GeTe peut être utilisé à la place du dioxyde de vanadium.

Les interrupteurs peuvent aussi être réalisés selon d'autres technologies et sans employer de matériau à changement de phase. Par exemple, les interrupteurs peuvent être des transistors tels que des transistors à effet de champs connus sous l'acronyme MOSFET (« Metal Oxide Semiconductor Field Effect Transistor »).

Le circuit 44 et ses interrupteurs peuvent être réalisés ailleurs que dans la couche 22. Par exemple, ils peuvent aussi être réalisés dans les couches diélectriques 28 et 30. Ils peuvent aussi être réalisés ou rapportés sur la surface extérieure de la couche 26.

L'inductance variable peut être utilisée pour réaliser d'autres circuits intégrés accordables. Par exemple, l'inductance variable décrite ici peut aussi avantageusement remplacer l'inductance variable dans l'un des circuits intégrés décrits dans la demande US5095357 et, en particulier, pour la réalisation des circuits des figures 18 et 19 de cette demande. L'inductance variable décrite ici peut aussi être utilisée pour réaliser des filtres passe-bas ou passe-haut.

Dans une autre variante, le condensateur 12 est un condensateur dont la capacité est variable et réglable à l'aide du circuit de réglage.

### Chapitre III. Avantages des modes de réalisation décrits ici :

Les bobines en forme de serpentin ne comportent pas de boucle. Elles génèrent donc beaucoup moins de courant de Foucault dans la couche conductrice ou semi-conductrice 22 du substrat sous-jacent. De plus, elles sont simples à fabriquer à l'aide des procédés conventionnels de fabrication de circuits intégrés. L'utilisation de bobines en forme de serpentin permet donc de limiter la génération de courant de Foucault sans complexifier la fabrication des circuits intégrés. En particulier, elles permettent, au moins dans certains cas, d'éviter d'avoir recours à l'utilisation de plan de masse pour isoler les bobines de la couche conductrice ou semi-conductrice 22.

Dans la première configuration, l'inductance de chaque bobine est égale à la différence entre son inductance propre et l'inductance mutuelle. Cette première configuration permet donc d'obtenir une valeur d'inductance très faible. A l'inverse, les deuxième et troisième configurations permettent d'obtenir des valeurs d'inductance beaucoup plus élevées. Ainsi, il est possible d'obtenir un rapport entre les valeurs L₃/L₁ ou L₂/L₁ bien plus élevées que ce qui est possible avec les inductances variables connues.

Le fait que l'une des configurations de l'inductance variable soit la première configuration permet d'obtenir un rapport entre les deux valeurs réglables de l'inductance supérieur à deux ou à 2,3 lorsque le coefficient k est supérieur à 0,4.

Le fait que le circuit de réglage comporte cinq interrupteurs permet à l'aide de seulement deux bobines d'obtenir trois valeurs différentes pour l'inductance.

Le fait que le circuit de réglage soit omis et que les bobines de l'inductance soient en permanence raccordées selon la première configuration et que la valeur absolue du coefficient k soit supérieure à 0,6 permet de réaliser simplement une inductance dont la valeur est très faible, c'est-à-dire inférieure à 100 pH ou 10 pH. De telles valeurs très faibles d'une inductance sont difficilement atteignables avec les inductances connues comportant deux bobines en forme de boucle. En effet, pour atteindre des valeurs aussi faibles avec des bobines en forme de boucle, il faut réduire la surface de la boucle. Or, plus la surface de la boucle diminue, plus la valeur de la capacité parasite augmente. L'augmentation de la capacité parasite dégrade les performances de l'inductance notamment à haute fréquence.

Agencer les bobines l'une par rapport à l'autre pour que le coefficient k soit supérieur à 0,9 permet d'obtenir une inductance dont la valeur est strictement inférieure à 100 pH ou 10 pH.

L'utilisation d'un noyau magnétique dont la perméabilité relative µᵣᵥ est supérieure à sa perméabilité relative µᵣₕ permet d'augmenter la valeur absolue du coefficient k. Or, plus la valeur absolue du coefficient k est importante, plus la valeur L₁ de l'inductance est faible.

Le fait que les projections orthogonales des bobines dans un plan horizontal se superposent à plus de 50 % permet d'augmenter la valeur absolue du coefficient k.

Un rapport e/I strictement inférieur à 1 permet d'obtenir un couplage magnétique vertical entre les bobines important et, en même temps, une valeur Lₚ pour les inductances propres des bobines 40, 42 importante. Cela permet donc de maximiser les valeurs L₂ et L₃ de l'inductance.

Le fait que le apport I/L soit inférieur à trois ou à un permet d'augmenter substantiellement l'écart entre la valeur L₁ et la valeur L₂ ou L₃ de l'inductance.

## Revendications

1. Circuit intégré comportant :
- un substrat (20) s'étendant principalement dans un plan appelé « plan du substrat »,
- une inductance (10 ; 130) comportant :
• une borne (10A) d'entrée,
• une borne (10B) de sortie, et
• une première et une deuxième bobines (40, 42 ; 140 ; 150 ; 160 ; 170 ; 180 ; 192 ; 202 ; 212 ; 222) couplées magnétiquement l'une à l'autre, ce couplage magnétique se traduisant par l'existence d'une inductance mutuelle M entre ces deux bobines lorsque l'inductance est alimentée, cette inductance mutuelle M étant définie par la relation suivante : M = k sqrt(L₄₀L₄₂), où :
- k est un coefficient de couplage magnétique, et
- L₄₀ et L₄₂ sont les inductances propres de, respectivement, la première et la deuxième bobines,
- sqrt(...) est la fonction racine carrée,
dans lequel :
- chacune des première et seconde bobines (40, 42 ; 140 ; 150 ; 160 ; 170 ; 180 ; 192 ; 202 ; 212 ; 222) comporte une ligne (50, 70) de métal qui s'étend continûment, dans un plan parallèle au plan du substrat et en avançant dans la même direction, entre une première et une seconde extrémités (52, 54 ; 72, 74), cette ligne de métal serpentant autour d'un axe (56) de la bobine parallèle au plan du substrat, cette ligne de métal comportant à cet effet une successions de brins (58-60 ; 142-144 ; 152-154; 162) qui coupent chacun l'axe de la bobine, et les brins de cette succession sont électriquement raccordés en série entre eux,
- l'inductance est une inductance variable (10 ; 130) dont la valeur de l'inductance varie entre des première et deuxième valeurs différentes, cette inductance variable comportant à cet effet un circuit (44 ; 100 ; 110) de réglage commandable apte à modifier le sens ou l'intensité du courant qui circule dans au moins l'une des première et deuxième bobines pour faire varier l'inductance mutuelle M et donc la valeur de l'inductance variable entre ses première et deuxième valeurs, et
- les axes (56) des première et deuxième bobines sont parallèles et chaque brin de la ligne de métal de la première bobine est immédiatement adjacent à un brin correspondant de la ligne de métal de la deuxième bobine,
**caractérisé en ce que** :
- la valeur absolue du coefficient k est comprise dans l'intervalle ┐0,4 ; 1┐, et
- le circuit de réglage comporte des interrupteurs commandables (76-80) agencés pour raccorder électriquement les première et deuxième bobines :
• selon une première configuration où les première et deuxième bobines sont raccordées en série et dans laquelle :
- la première extrémité (52) de la ligne (50) de métal de la première bobine (40) est directement raccordée à la borne (10B) de sortie,
- la seconde extrémité (54) de la ligne (50) de métal de la première bobine (40) est directement raccordée à la seconde extrémité (74) de la ligne (70) de métal de la deuxième bobine (42),
- la première extrémité (72) de la ligne (70) de métal de la deuxième bobine (42) est directement raccordée à la borne (10A) d'entrée,
de sorte que, pour chaque brin de la ligne de métal de la première bobine, le courant qui circule dans ce brin est en opposition de phase par rapport au courant qui circule au même moment dans le brin immédiatement adjacent de la ligne de métal de la deuxième bobine, et en alternance selon au moins une autre configuration choisie dans le groupe constitué d'une deuxième et d'une troisième configurations:
• selon une deuxième configuration où les première et deuxième bobines sont raccordées en série et :
- la première extrémité (52) de la ligne (50) de métal de la première bobine (40) est directement raccordée à la seconde extrémité (74) de la ligne (70) de métal de la deuxième bobine (42),
- la seconde extrémité (54) de la ligne (50) de métal de la première bobine (40) est directement raccordée à la borne (10B) de sortie,
- la première extrémité (72) de la ligne (70) de métal de la deuxième bobine (42) est directement raccordée à la borne (10A) d'entrée,
de sorte que, pour chaque brin de la ligne de métal de la première bobine, le courant qui circule dans ce brin est en phase avec le courant qui circule au même moment dans le brin immédiatement adjacent de la ligne de métal de la deuxième bobine, ou bien
• selon une troisième configuration où les première et deuxième bobines sont raccordées en parallèle et :
- la seconde extrémité (54) de la ligne (50) de métal de la première bobine (40) est directement raccordée à la borne (10B) de sortie et à la seconde extrémité (74) de la ligne (70) de métal de la deuxième bobine (42),
- la première extrémité (72) de la ligne (70) de métal de la deuxième bobine (42) est directement raccordée à la borne (10A) d'entrée et à la première extrémité (52) de la ligne (50) de métal de la première bobine (40),
de sorte que pour chaque brin de la ligne de métal de la première bobine, le courant qui circule dans ce brin est en phase avec le courant qui circule au même moment dans le brin immédiatement adjacent de la ligne de métal de la deuxième bobine.

2. Circuit intégré selon la revendication 1, dans lequel les interrupteurs commandables (76-80) du circuit de réglage sont agencés pour raccorder électriquement les première et deuxième bobines selon la première configuration et, en alternance, la deuxième configuration.

3. Circuit intégré selon l'une quelconque des revendications 1 et 2, dans lequel
- l'inductance comporte :
• la borne (10A) d'entrée du courant raccordée électriquement en permanence à la première extrémité (72) de la ligne (70) de métal de la deuxième bobine (42), et
• la borne (10B) de sortie du courant,
- le circuit (44) de réglage comporte :
• un premier interrupteur (76) apte à isoler électriquement et, en alternance, à raccorder électriquement directement les premières extrémités (52, 72) des lignes (50, 70) de métal des première et deuxième bobines (40, 42),
• un deuxième interrupteur (79) apte à isoler électriquement et, en alternance, à raccorder électriquement directement les deuxièmes extrémités (54, 74) des lignes (50, 70) de métal des première et deuxième bobines (40, 42),
• un troisième interrupteur (80) apte à isoler électriquement et, en alternance, à raccorder électriquement directement la deuxième extrémité (74) de la ligne (70) de métal de la deuxième bobine à la première extrémité (52) de la ligne (50) de métal de la première bobine (40),
• un quatrième interrupteur (77) apte à isoler électriquement et, en alternance, à raccorder électriquement directement la première extrémité (52) de la ligne (50) de métal de la première bobine à la borne (10B) de sortie du courant, et
• un cinquième interrupteur (78) apte à isoler électriquement et, en alternance, à raccorder électriquement directement la deuxième extrémité (54) de la ligne (50) de métal de la première bobine à la borne (10B) de sortie du courant.

4. Circuit intégré selon l'une quelconque des revendications 1 à 3, dans lequel la deuxième valeur de l'inductance est au moins deux fois plus grande que la première valeur.

5. Circuit intégré selon l'une quelconque des revendications précédentes, dans lequel les première et deuxième bobines (40, 42 ; 140 ; 150 ; 160 ; 170 ; 180 ; 192 ; 202 ; 212 ; 222) sont agencées l'une par rapport à l'autre de manière à ce que la valeur absolue du coefficient k de couplage magnétique soit supérieure à 0,6 ou à 0,9.

6. Circuit intégré selon l'une quelconque des revendications précédentes, dans lequel :
- les première et deuxième bobines (40, 42 ; 140 ; 150 ; 160 ; 170 ; 180 ; 192 ; 202 ; 212) sont réalisées, respectivement, dans une première et une deuxième couches (24, 26) de métallisation disposées l'une en dessous de l'autre dans une direction verticale perpendiculaire au plan du substrat, et
- le circuit intégré comporte un noyau magnétique (132) qui s'étend dans la direction verticale pour raccorder magnétiquement chaque brin de la ligne de métal de la première bobine au brin immédiatement adjacent de la ligne de métal de la deuxième bobine, ce noyau magnétique présentant une perméabilité relative µᵣᵥ dans la direction verticale supérieure à un et une perméabilité relative µᵣₕ dans une direction perpendiculaire à la direction verticale inférieure à la perméabilité µᵣᵥ.

7. Circuit intégré selon l'une quelconque des revendications précédentes, dans lequel :
- les première et deuxième bobines (40, 42 ; 140 ; 150 ; 160 ; 170 ; 180 ; 192 ; 202 212) sont disposées l'une en dessous de l'autre dans une direction perpendiculaire au plan du substrat, et
- la projection orthogonale de la première bobine sur un plan de projection parallèle au plan du substrat recouvre au moins 50 % de la projection orthogonale de la deuxième bobine sur ce même plan de projection.

8. Circuit intégré selon l'une quelconque des revendications précédentes, dans lequel :
- les première et deuxième bobines (40, 42 ; 140 ; 150 ; 160 ; 170 ; 180 ; 192 ; 202 212) sont disposées l'une en dessous de l'autre dans une direction verticale perpendiculaire au plan du substrat et espacée l'une de l'autre dans cette direction verticale d'une distance « e »,
- chaque brin immédiatement adjacent, dans la succession de brins, à un autre brin de la même bobine est espacé de cet autre brin d'une distance « I » mesurée le long de l'axe de cette bobine,
- pour chaque paire de brins immédiatement adjacent de cette même bobine, le rapport e/I est inférieur à 0,5.

9. Circuit intégré selon l'une quelconque des revendications précédentes, dans lequel, pour chaque bobine :
- chaque brin immédiatement adjacent, dans la succession de brins, à un autre brin de cette même bobine est espacé de cet autre brin d'une distance « I » mesurée le long de l'axe de cette bobine, et
- pour chaque paire de brins immédiatement adjacent de cette même bobine, le rapport I/L est inférieur à trois, où « L » est la largeur des brins de cette bobine dans une direction parallèle à l'axe de la bobine.

10. Circuit intégré selon l'une quelconque des revendications précédentes, dans lequel :
- chaque brin immédiatement adjacent, dans la succession de brins, à un autre brin est la réplique à l'identique de cet autre brin mais décalée, dans une direction parallèle à l'axe de la bobine, d'une distance prédéterminée, et
- les brins de la succession de brin sont électriquement raccordés en série entre eux de sorte que les courants aptes à circuler dans chaque paire de brins immédiatement adjacents sont systématiquement en opposition de phase lorsque la ligne de métal est alimentée par l'intermédiaire de ses extrémités.

## Patentansprüche

1. Integrierter Schaltkreis, der Folgendes umfasst:
- ein Substrat (20), das sich im Wesentlichen in einer Ebene, die als "Substratebene" bezeichnet wird, erstreckt,
- eine Induktivität (10; 130), die Folgendes umfasst:
• eine Eingangsklemme (10A),
• eine Ausgangsklemme (10B) und
• eine erste und eine zweite Spule (40, 42; 140; 150; 160; 170; 180; 192; 202; 212; 222), die magnetisch miteinander gekoppelt sind, wobei diese magnetische Kopplung das Vorhandensein einer gegenseitigen Induktivität M zwischen diesen zwei Spulen bewirkt, wenn die Induktivität mit Strom versorgt wird, wobei diese gegenseitige Induktivität M durch die folgende Beziehung definiert wird: M = k sqrt(L₄₀L₄₂), wobei:
- k ein magnetischer Kopplungskoeffizient ist und
- L₄₀ und L₄₂ die Eigeninduktivitäten der ersten bzw. der zweiten Spule sind,
- sqrt(...) die Quadratwurzelfunktion ist,
wobei:
- jede der ersten und der zweiten Spule (40, 42; 140; 150; 160; 170; 180; 192; 202; 212; 222) eine Metallleitung (50, 70) umfasst, die sich in einer zu der Substratebene parallelen Ebene und entlang derselben Richtung kontinuierlich zwischen einem ersten und einem zweiten Ende (52, 54; 72, 74) erstreckt, wobei sich diese Metallleitung um eine zu der Substratebene parallele Achse (56) der Spule schlängelt, wobei diese Metallleitung zu diesem Zweck eine Folge von Strängen (58-60; 142-144; 152-154; 162) umfasst, die jeweils die Achse der Spule kreuzen, und wobei die Stränge dieser Folge untereinander elektrisch in Reihe verbunden sind,
- die Induktivität eine variable Induktivität (10; 130) ist, deren Induktivitätswert zwischen einem ersten und einem zweiten Wert, die sich unterscheiden, variiert, wobei diese variable Induktivität zu diesem Zweck einen steuerbaren Einstellschaltkreis (44; 100; 110) umfasst, der fähig ist, die Richtung oder die Stärke des Stroms, der in mindestens einer der ersten und der zweiten Spule fließt, zu verändern, um die gegenseitige Induktivität M und somit den Wert der variablen Induktivität zwischen ihrem ersten und zweiten Wert zu variieren, und
- die Achsen (56) der ersten und der zweiten Spule parallel sind und jeder Strang der Metallleitung der ersten Spule direkt an einen entsprechenden Strang der Metallleitung der zweiten Spule angrenzt,
**dadurch gekennzeichnet, dass**:
- der Absolutwert des Koeffizienten k in dem Intervall ]0,4; 1] liegt und
- der Einstellschaltkreis steuerbare Schalter (76-80) umfasst, die angeordnet sind, um die erste und die zweite Spule folgendermaßen elektrisch zu verbinden:
• gemäß einer ersten Konfiguration, in der die erste und die zweite Spule in Reihe verbunden sind und wobei:
- das erste Ende (52) der Metallleitung (50) der ersten Spule (40) direkt mit der Ausgangsklemme (10B) verbunden ist,
- das zweite Ende (54) der Metallleitung (50) der ersten Spule (40) direkt mit dem zweiten Ende (74) der Metallleitung (70) der zweiten Spule (42) verbunden ist,
- das erste Ende (72) der Metallleitung (70) der zweiten Spule (42) direkt mit der Eingangsklemme (10A) verbunden ist,
sodass für jeden Strang der Metallleitung der ersten Spule der Strom, der in diesem Strang fließt, im Verhältnis zu dem Strom, der zu demselben Zeitpunkt in dem unmittelbar angrenzenden Strang der Metallleitung der zweiten Spule fließt, gegenphasig ist, und im Wechsel gemäß mindestens einer anderen Konfiguration, die aus der Gruppe ausgewählt ist, die aus einer zweiten und einer dritten Konfiguration besteht:
• gemäß einer zweiten Konfiguration, in der die erste und die zweite Spule in Reihe verbunden sind und:
- das erste Ende (52) der Metallleitung (50) der ersten Spule (40) direkt mit dem zweiten Ende (74) der Metallleitung (70) der zweiten Spule (42) verbunden ist,
- das zweite Ende (54) der Metallleitung (50) der ersten Spule (40) direkt mit der Ausgangsklemme (10B) verbunden ist,
- das erste Ende (72) der Metallleitung (70) der zweiten Spule (42) direkt mit der Eingangsklemme (10A) verbunden ist,
sodass für jeden Strang der Metallleitung der ersten Spule der Strom, der in diesem Strang fließt, mit dem Strom, der zu demselben Zeitpunkt in dem unmittelbar angrenzenden Strang der Metallleitung der zweiten Spule fließt, gleichphasig ist, oder aber
• gemäß einer dritten Konfiguration, in der die erste und die zweite Spule parallel verbunden sind und:
- das zweite Ende (54) der Metallleitung (50) der ersten Spule (40) direkt mit der Ausgangsklemme (10B) und mit dem zweiten Ende (74) der Metallleitung (70) der zweiten Spule (42) verbunden ist,
- das erste Ende (72) der Metallleitung (70) der zweiten Spule (42) direkt mit der Eingangsklemme (10A) und mit dem ersten Ende (52) der Metallleitung (50) der ersten Spule (40) verbunden ist,
sodass für jeden Strang der Metallleitung der ersten Spule der Strom, der in diesem Strang fließt, mit dem Strom, der zu demselben Zeitpunkt in dem unmittelbar angrenzenden Strang der Metallleitung der zweiten Spule fließt, gleichphasig ist.

2. Integrierter Schaltkreis nach Anspruch 1, wobei die steuerbaren Schalter (76-80) des Einstellschaltkreises angeordnet sind, um die erste und die zweite Spule gemäß der ersten Konfiguration und im Wechsel der zweiten Konfiguration elektrisch zu verbinden.

3. Integrierter Schaltkreis nach einem der Ansprüche 1 und 2, wobei
- die Induktivität Folgendes umfasst:
• die Stromeingangsklemme (10A), die mit dem ersten Ende (72) der Metallleitung (70) der zweiten Spule (42) dauerhaft elektrisch verbunden ist, und
• die Stromausgangsklemme (10B),
- der Einstellschaltkreis (44) Folgendes umfasst:
• einen ersten Schalter (76), der fähig ist, die ersten Enden (52, 72) der Metallleitungen (50, 70) der ersten und der zweiten Spule (40, 42) elektrisch zu isolieren und im Wechsel direkt elektrisch zu verbinden,
• einen zweiten Schalter (79), der fähig ist, die zweiten Enden (54, 74) der Metallleitungen (50, 70) der ersten und der zweiten Spule (40, 42) elektrisch zu isolieren und im Wechsel direkt elektrisch zu verbinden,
• einen dritten Schalter (80), der fähig ist, das zweite Ende (74) der Metallleitung (70) der zweiten Spule von dem ersten Ende (52) der Metallleitung (50) der ersten Spule (40) elektrisch zu isolieren und es im Wechsel direkt elektrisch damit zu verbinden,
• einen vierten Schalter (77), der fähig ist, das erste Ende (52) der Metallleitung (50) der ersten Spule von der Stromausgangsklemme (10B) elektrisch zu isolieren und es im Wechsel direkt elektrisch damit zu verbinden,
• einen fünften Schalter (78), der fähig ist, das zweite Ende (54) der Metallleitung (50) der ersten Spule von der Stromausgangsklemme (10B) elektrisch zu isolieren und es im Wechsel direkt elektrisch damit zu verbinden.

4. Integrierter Schaltkreis nach einem der Ansprüche 1 bis 3, wobei der zweite Wert der Induktivität mindestens doppelt so groß wie der erste Wert ist.

5. Integrierter Schaltkreis nach einem der vorhergehenden Ansprüche, wobei die erste und die zweite Spule (40, 42; 140; 150; 160; 170; 180; 192; 202; 212; 222) so zueinander angeordnet sind, dass der Absolutwert des magnetischen Kopplungskoeffizienten k größer als 0,6 oder als 0,9 ist.

6. Integrierter Schaltkreis nach einem der vorhergehenden Ansprüche, wobei:
- die erste und die zweite Spule (40, 42; 140; 150; 160; 170; 180; 192; 202; 212) jeweils in einer ersten und einer zweiten Metallisierungsschicht (24, 26) hergestellt sind, die in einer zu der Substratebene senkrechten vertikalen Richtung übereinander eingerichtet sind, und
- der integrierte Schaltkreis einen Magnetkern (132) umfasst, der sich in der vertikalen Richtung erstreckt, um jeden Strang der Metallleitung der ersten Spule magnetisch mit dem unmittelbar angrenzenden Strang der Metallleitung der zweiten Spule zu verbinden, wobei dieser Magnetkern in der vertikalen Richtung eine relative Permeabilität µᵣᵥ, die größer als eins ist, und in einer zu der vertikalen Richtung senkrechten Richtung eine relative Permeabilität µᵣₕ, die kleiner als die Permeabilität µᵣᵥ ist, aufweist.

7. Integrierter Schaltkreis nach einem der vorhergehenden Ansprüche, wobei:
- die erste und die zweite Spule (40, 42; 140; 150; 160; 170; 180; 192; 202; 212) in einer zu der Substratebene senkrechten Richtung übereinander eingerichtet sind und
- die orthogonale Projektion der ersten Spule auf eine zu der Substratebene parallele Projektionsebene mindestens 50% der orthogonalen Projektion der zweiten Spule auf diese gleiche Projektionsebene abdeckt.

8. Integrierter Schaltkreis nach einem der vorhergehenden Ansprüche, wobei:
- die erste und die zweite Spule (40, 42; 140; 150; 160; 170; 180; 192; 202; 212) in einer zu der Substratebene senkrechten vertikalen Richtung übereinander eingerichtet sind und in dieser vertikalen Richtung um einen Abstand "e" voneinander beabstandet sind,
- jeder unmittelbar an einen anderen Strang der gleichen Spule angrenzende Strang in der Folge von Strängen von diesem anderen Strang um einen Abstand "I" beabstandet ist, gemessen entlang der Achse dieser Spule,
- das Verhältnis e/l für jedes Paar von unmittelbar angrenzenden Strängen dieser gleichen Spule kleiner als 0,5 ist.

9. Integrierter Schaltkreis nach einem der vorhergehenden Ansprüche, wobei für jede Spule:
- jeder unmittelbar an einen anderen Strang dieser gleichen Spule angrenzende Strang in der Folge von Strängen von diesem anderen Strang um einen Abstand "I" beabstandet ist, gemessen entlang der Achse dieser Spule, und
- das Verhältnis I/L für jedes Paar von unmittelbar angrenzenden Strängen dieser gleichen Spule kleiner als drei ist, wobei "L" die Breite der Stränge dieser Spule in einer zu der Achse der Spule parallelen Richtung ist.

10. Integrierter Schaltkreis nach einem der vorhergehenden Ansprüche, wobei:
- jeder unmittelbar an einen anderen Strang angrenzende Strang in der Folge von Strängen die identische Nachbildung dieses anderen Strangs ist, der lediglich in einer zu der Achse der Spule parallelen Richtung um einen vorgegebenen Abstand versetzt ist, und
- die Stränge der Folge von Strängen untereinander elektrisch in Reihe verbunden sind, sodass die Ströme, die in jedem Paar von unmittelbar angrenzenden Strängen fließen können, systematisch gegenphasig sind, wenn die Metallleitung über ihre Enden mit Strom versorgt wird.

## Claims

1. Integrated circuit comprising:
- a substrate (20) that extends mainly in a plane called the "substrate plane",
- an inductor (10; 130) comprising:
• an input terminal (10A),
• an output terminal (10B), and
• a first and a second coil (40, 42; 140; 150; 160; 170; 180; 192; 202; 212; 222) which are magnetically coupled to one another, this magnetic coupling resulting in the presence of a mutual inductance M between these two coils when the inductor is energized, this mutual inductance M being defined by the following relationship: M = k sqrt(L₄₀L₄₂), where:
- k is a magnetic coupling coefficient, and
- L₄₀ and L₄₂ are the self-inductances of the first and second coils, respectively,
- sqrt(...) is the square root function,
wherein:
- each of the first and second coils (40, 42; 140; 150; 160; 170; 180; 192; 202; 212; 222) comprises a metal line (50, 70) which extends continuously, in a plane parallel to the substrate plane and advancing in the same direction, between a first and a second end (52, 54; 72, 74), this metal line following a winding path around an axis (56) of the coil parallel to the substrate plane, this metal line comprising for this purpose a succession of sections (58-60; 142-144; 152-154; 162) which each intersect the axis of the coil, and the sections of this succession are electrically connected in series with one another,
- the inductor is a variable inductor (10; 130), the inductance value of which varies between a first and a second value that differ from one another, this variable inductor comprising for this purpose a controllable adjusting circuit (44; 100; 110) which is able to change the direction or the intensity of the current flowing through at least one of the first and second coils so as to cause the mutual inductance M to vary and therefore the inductance value of the variable inductor to vary between its first and second values, and
- the axes (56) of the first and second coils are parallel and each section of the metal line of the first coil is immediately adjacent to a corresponding section of the metal line of the second coil,
**characterized in that**:
- the absolute value of the coefficient k is within the interval ]0.4; 1], and
- the adjusting circuit comprises controllable switches (76-80) designed to electrically connect the first and second coils:
• in a first configuration where the first and second coils are connected in series and in which:
- the first end (52) of the metal line (50) of the first coil (40) is directly connected to the output terminal (10B),
- the second end (54) of the metal line (50) of the first coil (40) is directly connected to the second end (74) of the metal line (70) of the second coil (42),
- the first end (72) of the metal line (70) of the second coil (42) is directly connected to the input terminal (10A),
so that, for each section of the metal line of the first coil, the current which flows through this section is in phase opposition relative to the current which flows at the same instant through the immediately adjacent section of the metal line of the second coil, and, alternately, in at least one other configuration chosen from the group consisting of a second and a third configuration:
• in a second configuration where the first and second coils are connected in series and:
- the first end (52) of the metal line (50) of the first coil (40) is directly connected to the second end (74) of the metal line (70) of the second coil (42),
- the second end (54) of the metal line (50) of the first coil (40) is directly connected to the output terminal (10B),
- the first end (72) of the metal line (70) of the second coil (42) is directly connected to the input terminal (10A),
so that, for each section of the metal line of the first coil, the current which flows through this section is in phase with the current which flows at the same instant through the immediately adjacent section of the metal line of the second coil, or
• in a third configuration where the first and second coils are connected in parallel and:
- the second end (54) of the metal line (50) of the first coil (40) is directly connected to the output terminal (10B) and to the second end (74) of the metal line (70) of the second coil (42),
- the first end (72) of the metal line (70) of the second coil (42) is directly connected to the input terminal (10A) and to the first end (52) of the metal line (50) of the first coil (40),
so that, for each section of the metal line of the first coil, the current which flows through this section is in phase with the current which flows at the same instant through the immediately adjacent section of the metal line of the second coil.

2. Integrated circuit according to Claim 1, wherein the controllable switches (76-80) of the adjusting circuit are designed to electrically connect the first and second coils in the first configuration and, alternately, the second configuration.

3. Integrated circuit according to either one of Claims 1 and 2, wherein:
- the inductor comprises:
• the current input terminal (10A), which is permanently electrically connected to the first end (72) of the metal line (70) of the second coil (42), and
• the current output terminal (10B),
- the adjusting circuit (44) comprises:
• a first switch (76), which is able to electrically isolate from one another and, alternately, to directly electrically connect to one another the first ends (52, 72) of the metal lines (50, 70) of the first and second coils (40, 42),
• a second switch (79), which is able to electrically isolate from one another and, alternately, to directly electrically connect to one another the second ends (54, 74) of the metal lines (50, 70) of the first and second coils (40, 42),
• a third switch (80), which is able to electrically isolate from one another and, alternately, to directly electrically connect to one another the second end (74) of the metal line (70) of the second coil and the first end (52) of the metal line (50) of the first coil (40),
• a fourth switch (77), which is able to electrically isolate from one another and, alternately, to directly electrically connect to one another the first end (52) of the metal line (50) of the first coil and the current output terminal (10B), and
• a fifth switch (78), which is able to electrically isolate from one another and, alternately, to directly electrically connect to one another the second end (54) of the metal line (50) of the first coil and the current output terminal (10B).

4. Integrated circuit according to any one of Claims 1 to 3, wherein the second inductance value is at least twice as great as the first value.

5. Integrated circuit according to any one of the preceding claims, wherein the first and second coils (40, 42; 140; 150; 160; 170; 180; 192; 202; 212; 222) are arranged relative to one another in such a way that the absolute value of the magnetic coupling coefficient k is greater than 0.6 or greater than 0.9.

6. Integrated circuit according to any one of the preceding claims, wherein:
- the first and second coils (40, 42; 140; 150; 160; 170; 180; 192; 202; 212) are formed, respectively, in a first and a second metallization layer (24, 26), which are arranged one below the other in a vertical direction perpendicular to the substrate plane, and
- the integrated circuit comprises a magnetic core (132) which extends in the vertical direction so as to magnetically connect each section of the metal line of the first coil to the immediately adjacent section of the metal line of the second coil, this magnetic core having a relative permeability µᵣᵥ in the vertical direction greater than one and a relative permeability µᵣₕ in a direction perpendicular to the vertical direction less than the permeability µᵣᵥ.

7. Integrated circuit according to any one of the preceding claims, wherein:
- the first and second coils (40, 42; 140; 150; 160; 170; 180; 192; 202; 212) are arranged one below the other in a direction perpendicular to the substrate plane, and
- the orthogonal projection of the first coil on a projection plane parallel to the substrate plane covers at least 50% of the orthogonal projection of the second coil on this same projection plane.

8. Integrated circuit according to any one of the preceding claims, wherein:
- the first and second coils (40, 42; 140; 150; 160; 170; 180; 192; 202; 212) are arranged one below the other in a vertical direction perpendicular to the substrate plane and spaced apart from one another in this vertical direction by a distance "e",
- each section immediately adjacent, in the succession of sections, to another section of the same coil is spaced apart from this other section by a distance "I" measured along the axis of this coil,
- for each pair of immediately adjacent sections of this same coil the ratio e/I is less than 0.5.

9. Integrated circuit according to any one of the preceding claims, wherein, for each coil:
- each section immediately adjacent, in the succession of sections, to another section of this same coil is spaced apart from this other section by a distance "I" measured along the axis of this coil, and
- for each pair of immediately adjacent sections of this same coil, the ratio I/L is less than three, where "L" is the width of the sections of this coil in a direction parallel to the axis of the coil.

10. Integrated circuit according to any one of the preceding claims, wherein:
- each section immediately adjacent, in the succession of sections, to another section is the identical replica of this other section, but offset, in a direction parallel to the axis of the coil, by a predetermined distance, and
- the sections in the succession of sections are electrically connected in series with one another such that the currents which are able to flow through each pair of immediately adjacent sections are always in phase opposition when the metal line is energized via its ends.
